# EUROPEAN PATENT SPECIFICATION

(11) **EP 1 928 008 B1**
(45) Date of publication and mention of the grant of the patent: **24.02.2010**
(21) Application number: 07121845.7
(22) Date of filing: 29.11.2007
(51) Int. Cl.: H01H 13/48, H05K 3/30

(54) **Arrangement for surface mounting an electrical component by soldering, and electrical component for such an arrangement**
Anordnung für die Oberflächenmontage eines elektrischen Bauteils durch Löten und elektrisches Bauteil für eine solche Anordnung
Arrangement pour le montage par soudage en surface d'un composant electrique, et composant electrique pour un tel agencement

(30) Priority: 01.12.2006 FR 0655260
(43) Date of publication of application: 04.06.2008
(73) Proprietor: CoActive Technologies, Inc., Greenwich CT 06830 (US)
(72) Inventor: Villain, Jean-Christophe, 39100 Dole (FR); Cour, Michel, 39100 Sampans (FR)
(74) Representative: Kohn, Philippe

(56) References cited:
- WO-A-97/31383
- US-A- 4 484 042
- US-A- 4 803 321
- US-A- 5 315 070
- US-A1- 2005 248 031
- US-B1- 7 057 128

## Description

### TECHNICAL FIELD OF THE INVENTION

The present invention relates to an arrangement for surface mounting an electrical component on a substrate by soldering, especially by reflow soldering.

The invention also relates to an electrical component for an arrangement according to the invention, and especially an electrical switch.

### PRIOR ART

The invention relates more particularly to an arrangement of the type comprising:
- a substrate, such as for example a printed-circuit board, an upper face of which comprises a plurality of conducting connection pads; and
- an electrical component which comprises:
   * a base made of insulating material in the general form of a plate bounded by a lower face which extends opposite a portion of the upper face of the substrate, this component being subjected to an actuation force applied along a direction generally orthogonal to the plane of the base; and
   * a plurality of connection terminals arranged on the periphery of the base, each of which is electrically connected to a corresponding connection pad of the upper face of the substrate by means of a spot of solder paste.

Components of this type in particular include miniaturized electrical switches or "navigators" (which are multi-channel switch control members with which electronic appliances are equipped, such as portable telephones, personal digital assistants, etc.).

The manual actuation of the component, for example by means of a push-button or an actuation rod, allows its user to produce an electrical signal, for example an enable or selection signal, by establishing an electrical switching channel.

For this purpose, the user applies an actuation force to the component, for example to the electrical switch, this force being of vertical orientation, i.e. orthogonal to the general plane of the base, which by convention is considered to be in a horizontal orientation. The force applied by the user is always greater than the minimum force needed to establish the electrical switching channel and the actuation thus results in an excessive force being applied to the electrical component, and especially to its base, thus running the risk of damaging the component, especially by deforming the insulating base.

Such a risk of damaging the component is greater when the component, for example an electrical switch, is very small since the thicknesses of insulating plastic constituting in particular the base are very small, and therefore all the more easily subjected to permanent plastic deformation.

Such deformation is not permissible as it generally renders the component unusable, or modifies its operating characteristics unacceptably.

US-A-4 803 321 (ITT) describes and shows an electrical switch comprising a base made of insulating plastic, which is capable of bearing on the upper face of a printed-circuit board. The electrical connection terminals of the switch for connecting it to the conducting tracks of the printed-circuit board are of the type to be inserted into holes in the printed-circuit board. To avoid excessively large deformation of the insulating base when a vertical actuation force F is applied to the push-button, the central part of the base includes a foot, moulded as one with the base, which extend vertically as far as the upper face of the printed-circuit board.

Such a design has in particular the drawback of increasing the total height of the component and is not suitable for the technique of surface mounting by reflow soldering. During the soldering operation, the component "rises" by a variable amount, which amount may become critical and not admissible for a very thin component.

### SUMMARY OF THE INVENTION

The invention provides an arrangement of the abovementioned type, characterized in that it includes a block which is interposed vertically between the upper face of the substrate and a facing portion of the lower face of the base of the component, which block is located substantially in line with the axis of application of said force in order to avoid deformation of the base, and in that said block consists of a spot of solder paste that is soldered to a conducting pad associated with the upper face of the substrate.

Thus, the invention makes advantageous use of the technique of surface mounting by soldering to produce a block forming a spacer between the lower face of the base and the upper face of the printed-circuit board, which block itself consists of solder paste.

The invention also provides a component for an arrangement according to the invention exhibiting the following features:
- the facing portion of the lower face of the base of the component is a conducting mount that can be soldered to said block;
- the portion of the lower face of the base is a portion made of insulating material;
- the portion of the lower face of the base is shaped so as to be able to cooperate with said block;
- the portion of the lower face of the base includes a housing that can accommodate the upper portion of said block;
- said portion of the lower face of the base includes a point that can be accommodated in the upper portion of said block;
- the component is an electrical switch of the type comprising said base, which defines a cavity open at the top, at least one central fixed contact and at least one lateral fixed contact, which are placed in said cavity, and a generally dome-shaped trip member received in the cavity and the periphery of which is in electrical contact with the lateral fixed contact, said trip member being elastically deformable in order to establish an electrical connection between the two fixed contacts when this member is subjected to said actuation force; and
- the outline of said base is rectangular and it includes four connection terminals placed at the corners of the base.

### BRIEF DESCRIPTION OF THE DRAWINGS

Other features and advantages of the invention will become apparent on reading the following detailed description, for the understanding of which reference will be made to the appended drawings in which:
- Figure 1 is an exploded perspective schematic view of an arrangement according to the invention comprising a printed-circuit board and an electrical switch;
- Figure 2 is a sectional view in a vertical mid-plane of the electrical switch of Figure 1 in the assembled position of its various constituent parts and in a position in which it is soldered to the printed-circuit board with its block of solder paste;
- Figure 3 is a perspective view from below of the electrical switch shown in Figure 1;
- Figure 4 is a perspective view from above of the base made of insulating plastic of the electrical switch with its fixed contacts and its connection terminals;
- Figure 5 is a perspective view from above of the fixed contacts, over which the base made of insulating plastic of Figure 4 is overmoulded;
- Figures 6 to 9 are various views corresponding to the central part of Figure 1 , which schematically illustrate alternative embodiments of the arrangement according to the invention.

### DETAILED DESCRPTION OF THE DRAWINGS

In the following description, identical, analogous or similar elements will be denoted by the same references.

Without being restricting, and for the purpose of making it easier to understand the description and the claims, the terms "vertical", "horizontal", "upper", "lower", etc. will be used with reference to the vertical axis V of the figures, which forms part of the orthogonal coordinate system L, V, T indicated in the figures, solely by convention and without any reference to the Earth's gravity.

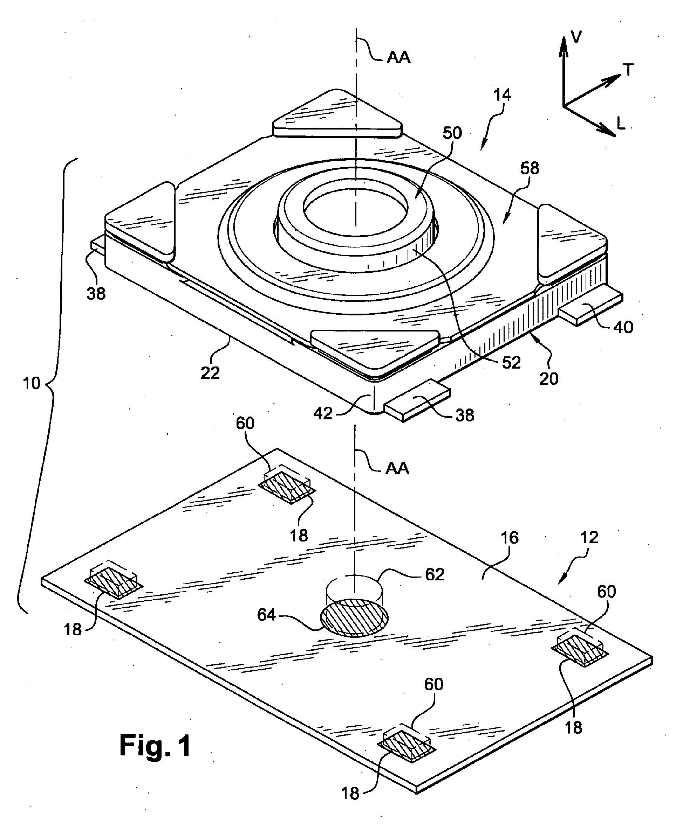

Figure 1 shows an arrangement 10 essentially consisting of a lower printed-circuit board 12 and an electrical switch 14, which is an electrical component that can be surface mounted on and fastened to the upper face 16 of the board 12 by soldering.

As is known, the upper face 16 includes a plurality of conducting connection pads among which here are the four connection pads 18 placed at the four corners of a rectangle, each pad having a rectangular outline.

Each of the connection pads 18 can be connected, here by soldering, to a corresponding connection terminal of the electrical switch 14.

As is known, the electrical switch 14 has a lower base 20 which here is in the general form of a rectangular plate, produced by moulding with an insulating plastic and bounded by its plane lower face 22 and by its plane upper face 24.

The insulating base 20 essentially includes a central cavity 26 of cylindrical general shape, which is open vertically at the top and is bounded by its cylindrical lateral wall 28 and by its horizontal bottom wall 30 parallel to the lower face 22.

As is known, the horizontal bottom 30 of the cavity 26 includes a central insert 32 constituting a fixed central electrical contact and includes a peripheral ring 34 constituting a fixed lateral contact, these two fixed electrical contacts being placed with their upper contact faces parallel and flush with the bottom 30.

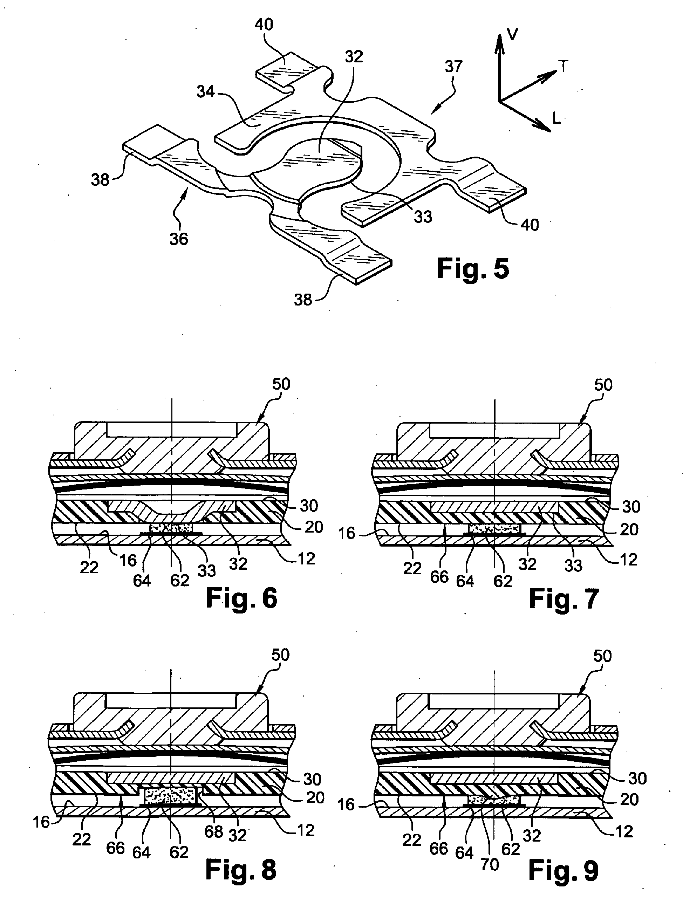

As may be seen in Figure 5, the fixed central electrical contact 32 forms part of the cut metal contact plate 36, which also includes two connection terminals 38.

Likewise, the annular lateral electrical contact 34 forms part of a cut metal plate 37, which also includes two connection terminals 40.

After the base 20 has been overmoulded onto the plates 36 and 37, the four connection terminals, in the form of two pairs of terminals 38 and 40 respectively, are placed substantially at the four corners 42 of the base 20, the contour of which here is rectangular.

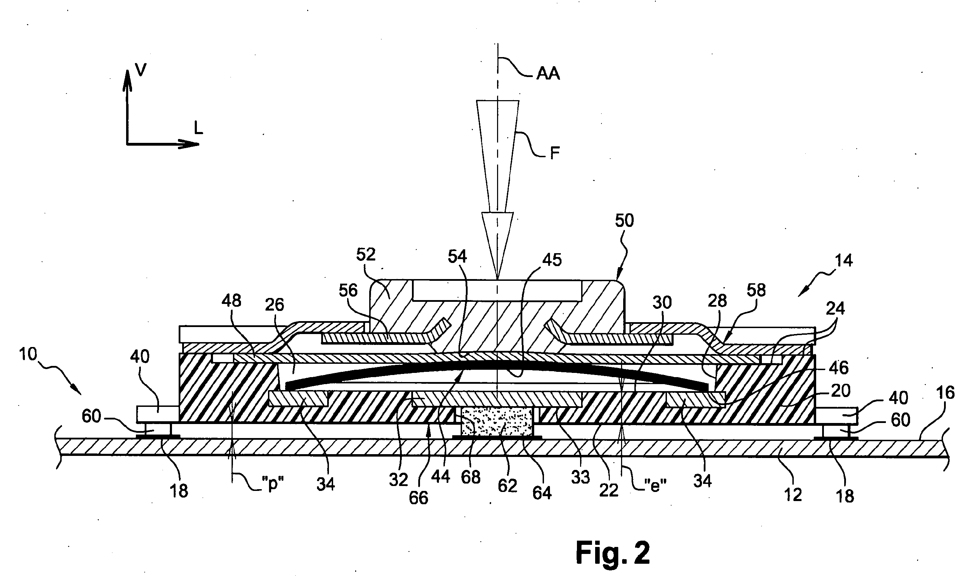

As may be seen in particular in Figure 2, after overmoulding, the horizontal plane lower face of each terminal 38, 40 is substantially flush with the plane of the lower face 22 of the base 20.

As is known, to establish an electrical switching channel between the fixed contact 32 and the fixed contact 34, the electrical switch 14 includes a central trip member 44, of known general design and here with a circular dome shape, which rests on the upper face of the lateral fixed contact 34 and the central part of which extends so as to face the central fixed contact 32 with which this central part can come into electrical contact in order to establish the electrical switching channel.

The cavity 26 with its trip member 44 in place is closed off by a sealing film 48.

To change the state of the trip member 44, which is illustrated in its rest position in Figure 2, the electrical switch being of the normally-open type, the switch 14 includes an actuation member 50, here made in the form of a central push-button.

The push-button 50 constituting the actuation member has a central body 52 bounded by a plane lower horizontal actuation face 54, which is capable of acting on the central part 45 of the trip member 44. As an example, the body here is made of a plastic overmoulded onto a strip of metal.

The body 52 is overmoulded onto a retaining plate 56, allowing the push-button to be held and retained in relation to the base 20 by means of an upper closure plate 58 of rectangular outline, which is fastened to the base 20 at its four corners.

To trip the member 44, an actuation force F is exerted on the actuation member 50, said force being applied generally vertically along the central vertical axis A-A of the switch, which corresponds substantially to the central axis of the trip member 44.

When the force F is applied, the trip member 44 changes state and establishes the switching channel, and the actuation member then applies the force F to the central part of the insulating base 20, which is a part of small thickness "e" corresponding to the distance between the faces 22 and 30.

The switch 14 with its connection terminals 40 is an electrical component shaped so as to be fastened to the upper face 16 of the board 12 by soldering, using the technique of surface mounting.

Using this known soldering technique, each connection terminal 38, 40 is electrically connected or joined to a conducting connection plate 18 of the board 12 via a block 60 of solder paste, also called a spot of solder paste.

After reflow soldering, the spots 60 of solder paste provide, on the one hand, the electrical connection and, on the other hand, the fastening of the electrical component, here the switch 14, to the upper face 16 of the substrate 12.

It is to ensure good fastening and good geometrical balancing of the component 14 after soldering that there are four connection terminals 38 and 40, whereas only two terminals 38 and 40 would be sufficient to provide electrical connection for the two fixed contacts 32 and 34.

As may be seen in Figure 2, owing to the use of the surface soldering technique, a vertical gap "p" exists between the lower face 22 of the base 20 and the upper face 16 of the printed-circuit board 12.

Because of the increasing miniaturization of electrical components, all the dimensions are small, the central thickness "e" of the base in particular becoming smaller and smaller.

As a result, applying the actuation force F may lead to a temporary and/or permanent deformation of the base 20, which flexes in its central part so as to bear on the upper face 16.

To avoid such deformation, the arrangement 10 includes a block 62 forming a spacer stay, which is interposed vertically between the upper face 16 of the substrate 14 and a facing portion of the lower face 22 of the insulating base 20.

The block 62 is located substantially in line with the axis A-A of application of the actuation force F so as to prevent the base deforming in its central part.

Advantageously, the block 62 is formed by a spot of solder paste, which is soldered, during the reflow soldering operation, to an associated additional connection pad 64 on the upper face 16 of the substrate board 12.

Thus, the block 62 is advantageously formed simply by solder paste, which is put into position on the associated connection pad 64 and which, after reflow soldering, cooperates with a portion 66, here a central portion, of the lower face 22.

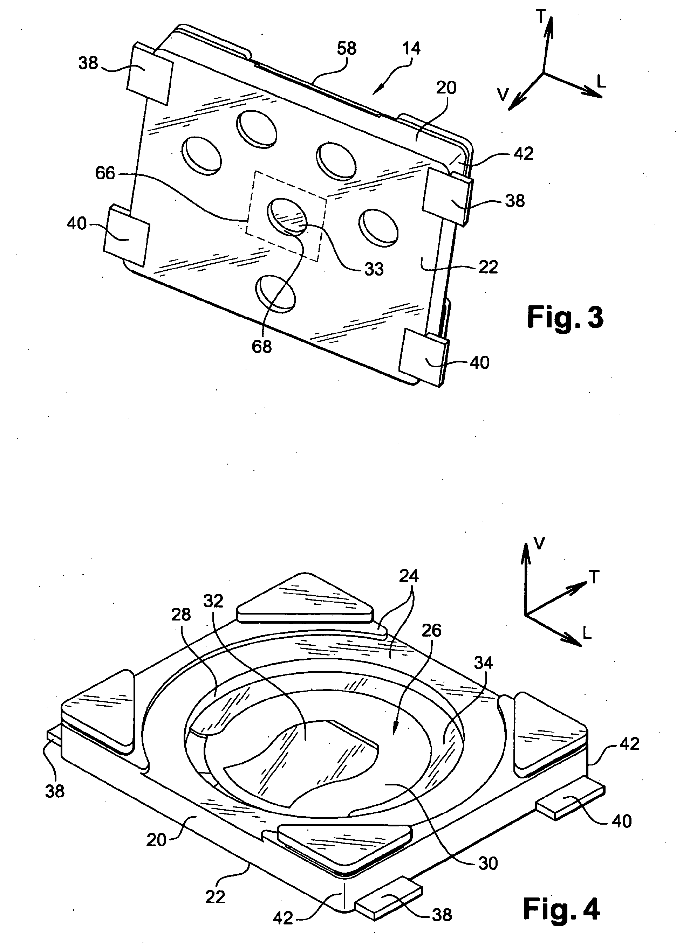

In the first embodiment illustrated schematically in Figures 1 to 5, the insulating base 20 includes, in the central portion 66, a cylindrical recess 68 which "bares" a plane horizontal facing portion of the lower face 33 of the central electrical contact 32.

The recess 68 is for example obtained during the overmoulding operation by means of a mould ejector that cooperates with the face 33.

In such a situation, the block 62 of solder paste is soldered to the connection pad 64 and to the fixed electrical contact 32.

Thanks to the presence of the block 62, it will be understood that the actuation force F is mechanically transmitted directly to the board 12 essentially without causing the insulating base 20 to deform.

In the alternative embodiment illustrated in Figure 6, the central insert constituting the fixed contact 32 includes a bump projecting vertically downwards, so that its lower face 33 is substantially flush with the lower face 22 of the base 20.

The recess 68 thus provides access to a conducting mount 33, here belonging to the fixed central contact 32 to which the block 62 may be soldered. However, such a conducting mount for soldering the upper portion of the block 62 does not necessarily form part of one of the electrical contacts of the switch 14.

In the alternative embodiment illustrated in Figure 7, the central portion 66 of the lower face 22 of the base 20 is a portion made of insulating material, the block 62 being soldered only to the connection pad 64 of the board 12.

Figure 8 is an embodiment similar to that shown in Figure 7, in which the central portion 66 is made of insulating material and is also shaped with a recess 68 so as to be capable of cooperating with the upper portion of the block 62, the recess 68 helping to produce the block 62 during the reflow soldering operation by "keeping" the solder paste in the corresponding region.

Finally, Figure 9 shows another conformation of the central part 66 made of insulating material, here in the form of a tip 70 which projects preferably downwards and is accommodated in the upper portion of the block 62.

## Claims

1. Arrangement (10) for surface mounting an electrical component (14) on a substrate (12), especially on a printed-circuit board, by soldering, which arrangement is of the type comprising:
- a substrate (12) an upper face (16) of which comprises a plurality of conducting connection pads (18); and
- an electrical component (14) which comprises:
* a base (20) made of insulating material in the general form of a plate bounded by a lower face (22) which extends opposite a portion of the upper face (16) of the substrate (12), this component being subjected to an actuation force (F) applied along a direction generally orthogonal to the plane of the base; and
* a plurality of connection terminals (38, 40) arranged on the periphery of the base (20), each of which is electrically connected to a corresponding connection pad (18) of the upper face (16) of the substrate (12) by means of a spot (60) of solder paste,
**characterized in that** the arrangement includes a block (62) which is interposed vertically between the upper face (16) of the substrate (12) and a facing portion (66) of the lower face (22) of the base (20) of the component, which block (62) is located in line with the axis (A-A) of application of said force (F) in order to avoid deformation of the base (20), and **in that** said block (62) consists of a spot of solder paste that is soldered to a conducting pad (64) associated with the upper face (16) of the substrate (12).

2. Electrical component for an arrangement according to Claim 1, **characterized in that** said facing portion (66) of the lower face (22) of the base (20) of the component (14) is a conducting mount (33) that can be soldered to said block (62).

3. Electrical component for an arrangement according to Claim 1, **characterized in that** said portion (66) of the lower face (22) of the base (20) is a portion made of insulating material.

4. Electrical component for an arrangement according to Claim 1, **characterized in that** said portion (66) of the lower face (22) of the base (20) is shaped so as to be able to cooperate with said block (62).

5. Electrical component according to Claim 4, **characterized in that** said portion (66) of the lower face (22) of the base (20) includes a housing (68) that can accommodate the upper portion of said block (62).

6. Electrical component according to Claim 4, **characterized in that** said portion (66) of the lower face (22) of the base (20) includes a point (70) that can be accommodated in the upper portion of said block (62).

7. Electrical component for an arrangement according to Claim 1, **characterized in that** this component is an electrical switch (14) of the type comprising said base (20), which defines a cavity (26) open at the top, at least one central fixed contact (32) and at least one lateral fixed contact (34), which are placed in said cavity, and a generally dome-shaped trip member (44) received in the cavity (26) and the periphery (46) of which is in electrical contact with the lateral fixed contact (34), said trip member being elastically deformable in order to establish an electrical connection between the two fixed contacts (32, 34) when this member is subjected to said actuation force (F).

8. Electrical component according to Claim 7, **characterized in that** the outline of said base (20) is rectangular and **in that** it includes four connection terminals (38, 40) placed at the corners of the base.

## Patentansprüche

1. Anordnung (10) für die Oberflächenmontage eines elektrischen Bauteils (14) auf einem Substrat (12), insbesondere auf einer Leiterplatte, durch Löten, wobei die Anordnung folgendes aufweiset :
- ein Substrat (12), dessen Oberseite eine Vielzahl leitender Anschluss-Pads (18) aufweist ; und
- ein elektrisches Bauteils (14), das folgendes aufweist:
eine Basis (20) aus Isoliermaterial in der allgemeinen Form einer Platte, die von einer Unterseite (22) begrenzt wird, die gegenüber einem Abschnitt der Oberseite (16) des Substrates (12) verläuft, wobei dieses Bauteil einer Betätigungskraft (F) unterworfen ist, die entlang einer Richtung angewendet wird, welche im allgemeinen orthogonal zu der Ebene der Basis verläuft ; und
eine Vielzahl von Anschlussklemmen (38, 40), die am Umfang der Basis (20) angeordnet sind, wobei jede mit einem Anschluss-Pad (18) der Oberseite (16) des Substrates (12) mittels eines Punktes (60) einer Lötpaste elektrisch verbunden ist,
**dadurch gekennzeichnet, dass** die Anordnung ein Ausgleichsstück (62) aufweist, das zwischen der Oberseite des Substrates (12) und einer gegenüberliegenden Seite (66) der Unterseite (22) der Basis des Bauteils eingeschoben ist, wobei das Ausgleichsstück (62) mit der Achse (A-A) der Anwendung der Kraft (F) übereinstimmt, um eine Verformung der Basis zu vermeiden, und dass das Ausgleichsstück (62) aus einem Punkt Lötpaste besteht, die an ein leitendes Pad (64) angelötet ist, welches mit der Oberseite des Substrates (12) verbunden ist.

2. Elektrisches Bauteil für eine Anordnung nach Anspruch 1, **dadurch gekennzeichnet, dass** es sich bei dem gegenüberliegenden Abschnitt (66) der Unterseite (22) der Basis (20) des Bauteils (14) um eine leitende Unterlage (33) handelt, die an das Ausgleichsstück (62) angelötet werden kann.

3. Elektrisches Bauteil für eine Anordnung nach Anspruch 1, **dadurch gekennzeichnet, dass** es sich bei dem Abschnitt (66) der Unterseite (22) der Basis (20) um einen Abschnitt aus Isoliermaterial handelt.

4. Elektrisches Bauteil für eine Anordnung nach Anspruch 1, **dadurch gekennzeichnet, dass** der Abschnitt (66) der Unterseite (22) der Basis (20) derart geformt ist, dass er mit dem Ausgleichsstück (62) zusammenwirken kann.

5. Elektrisches Bauteil nach Anspruch 4, **dadurch gekennzeichnet, dass** der Abschnitt (66) der Unterseite (22) der Basis (20) ein Gehäuse (68) einschließt, das den oberen Abschnitt des Ausgleichsstückes (62) aufnehmen kann.

6. Elektrisches Bauteil nach Anspruch 4, **dadurch gekennzeichnet, dass** der Abschnitt (66) der Unterseite (22) der Basis (20) einen Punkt (70) einschließt, der in dem oberen Abschnitt des Ausgleichsstückes (62) aufgenommen werden kann.

7. Elektrisches Bauteil für eine Anordnung nach Anspruch 1, **dadurch gekennzeichnet, dass** es sich bei diesem Bauteil um einen elektrischen Schalter (14) handelt, der die Basis (20) aufweist, welche einen Hohlraum (26) bildet, der oben offen ist, mindestens einen mittleren, feststehenden Kontakt (32) und mindestens einen seitlichen, feststehenden Kontakt (34), die in dem Hohlraum (26) angeordnet sind, und ein im allgemeinen kuppelförmiges Auslöseelement (44), das in dem Hohlraum (26) aufgenommen wird, und dessen Umfang (46) in elektrischem Kontakt mit dem seitlichen, feststehenden Kontakt (34) steht, wobei das Auslöseelement elastisch verformbar ist, um eine elektrische Verbindung zwischen den beiden feststehenden Kontakten (32, 34) herzustellen, wenn dieses Element der Betätigungskraft (F) unterworfen wird.

8. Elektrisches Bauteil nach Anspruch 7, **dadurch gekennzeichnet, dass** der Umfang der Basis (20) rechteckig ist, und dass sie vier Anschlussklemmen (38, 40) aufweist, die in den Ecken der Basis angeordnet sind.

## Revendications

1. Agencement (10) pour le montage par soudage en surface d'un composant électrique (14) sur un substrat (12), notamment sur une plaque à circuits imprimés, agencement du type qui comporte :
- un substrat (12) dont une face supérieure (16) comporte une pluralité de plages conductrices de connexion (18) ; et
- un composant électrique (14) comportant :
* une embase (20) en matériau isolant en forme générale de plaque délimitée par une face inférieure (22) qui s'étend en vis-à-vis d'une portion de la face supérieure (16) du substrat (12), ce composant étant soumis à une force d'actionnement (F) appliquée selon un axe globalement orthogonal au plan de l'embase ; et
* une pluralité de bornes de connexion (38, 40) agencées à la périphérie de l'embase (20) dont chacune est connectée électriquement à une plage de connexion correspondante (18) de la face supérieure (16) du substrat (12) au moyen d'un bossage (60) de pâte de soudure ;
**caractérisé en ce que** l'agencement comporte une cale (62) qui est interposée verticalement entre la face supérieure (16) du substrat (12) et une portion (66) en vis-à-vis de la face inférieure (22) de l'embase (20) du composant, ladite cale (62) étant située sensiblement au droit de l'axe (A-A) d'application de ladite force (F) pour éviter une déformation de l'embase (20), et **en ce que** ladite cale (62) est constituée par un bossage de pâte de soudure qui est soudé sur une plage conductrice (64) associée de la face supérieure (16) du substrat (12).

2. Composant électrique pour un agencement selon la revendication 1, **caractérisé en ce que** ladite portion (66) en vis-à-vis de la face inférieure (22) de l'embase (20) du composant (14) est un plot conducteur (33) qui est apte à être soudé à ladite cale (62).

3. Composant électrique pour un agencement selon la revendication 1, **caractérisé en ce que** ladite portion (66) de la face inférieure (22) de l'embase (20) est une portion en matériau isolant.

4. Composant électrique pour un agencement selon la revendication 1, **caractérisé en ce que** ladite portion (66) de la face inférieure (22) de l'embase (20) est conformée de manière à être apte coopérer avec ladite cale (62).

5. Composant électrique selon la revendication 4, **caractérisé en ce que** ladite portion (66) de la face inférieure (22) de l'embase (20) comporte un logement (68) apte à recevoir le tronçon supérieur de ladite cale (62).

6. Composant électrique selon la revendication 4, **caractérisé en ce que** ladite portion (66) de la face inférieure (22) de l'embase (20) comporte une pointe (70) apte à être reçue dans le tronçon supérieur de ladite cale (62).

7. Composant électrique pour un agencement selon la revendication 1, **caractérisé en ce que** ce composant est un commutateur électrique (14) du type comportant ladite embase (20) qui délimite une cavité (26) ouverte vers le haut, au moins un contact fixe central (32) et au moins un contact fixe latéral (34) agencés dans ladite cavité, un organe (44) de déclenchement en forme générale de dôme reçu dans la cavité (26) et dont la périphérie (46) est en contact électrique avec le contact fixe latéral (34) et qui est déformable élastiquement pour établir une connexion électrique entre les deux contacts fixes (32, 34) lorsque cet organe est soumis à ladite force d'actionnement (F).

8. Composant électrique selon la revendication 7, **caractérisé en ce que** le contour de ladite embase (20) est rectangulaire, et **en ce qu'**il comporte quatre bornes de connexion (38, 40) agencées aux coins de l'embase.
